# EUROPEAN PATENT APPLICATION

(11) **EP 3 190 463 A1**
(43) Date of publication of application: **12.07.2017**
(21) Application number: 15837379.5
(22) Date of filing: 07.09.2015
(51) Int. Cl.: G03F 7/033, C08F 8/30, C08F 220/20, G03F 7/004, G03F 7/027, G03F 7/40

(54) **PHOTOSENSITIVE ELECTROLESS PLATING UNDERCOAT AGENT**

(30) Priority: 05.09.2014 JP 2014181497
(71) Applicant: Nissan Chemical Industries, Ltd., Chiyoda-ku Tokyo 101-0054 (JP)
(72) Inventor: KOJIMA, Keisuke, Funabashi-shi Chiba 274-0052 (JP)
(74) Representative: Hoffmann Eitle
(86) International application number: PCT/JP2015/075367
(87) International publication number: WO 2016/035897

(57) **Abstract**

The object of the present invention is to provide a new primer for electroless plating for use in a pretreatment process of electroless plating, which is environmentally friendly, can be treated in fewer process steps, and can facilitate formation of fine-pitch wiring with a width of a few µm by photolithography. A photosensitive primer for forming a metal plating film on a base material through an electroless plating process comprises (a) a hyperbranched polymer having an ammonium group at a molecular terminal and a weight-average molecular weight of 1,000 to 5,000,000, (b) metal fine particles, (c) a polymerizable compound having three or more (meth)acryloyl groups in a molecule, and (d) a photopolymerization initiator.

## Description

### TECHNICAL FIELD

The present invention relates to a photosensitive primer including a hyperbranched polymer, metal fine particles, a polymerizable compound, and a photopolymerization initiator.

### BACKGROUND ART

Recent miniaturization of devices such as personal computers, mobile phones, and wearable terminals has required techniques for easily forming fine-pitch wiring patterns in order to increase the density of patterns and form wiring with high transmittance and high visibility on transparent substrates.

A method is disclosed as one of the means for forming fine-pitch wiring, in which electroless plating is performed after an electroless plating catalyst is patterned by photolithography (Patent Document 1). Specifically, a material including a photosensitive resin mixed with a metal complex, metal ion, metal colloid, or the like serving as a catalyst for electroless plating is used to form an undercoat with any given pattern such as a grid-like pattern by UV exposure through a photomask and development, and electroless plating is applied on this undercoat to obtain a conductive pattern.

Another example is disclosed, in which a composition including a hyperbranched polymer having an ammonium group and Pd fine particles is used as a primer for electroless plating whereby an electroless plating is formed simply by direct immersion in an electroless plating solution without passing through an activation process after coating application (Patent Document 2).

### Prior Art Documents

### Patent Documents

Patent Document 1: Japanese Patent Application Publication No. H11-170421 (JP H11-170421 A)
Patent Document 2: WO2012/14121 Pamphlet

### SUMMARY OF THE INVENTION

### Problem to be Solved by the Invention

In Patent Document 1 above, a protective colloid such as PVP, a surfactant such as dodecylbenzenesulphonic acid, or the like is used as a stabilizer for the metal colloid. However, there is a concern of stability of varnish due to decomposition of the protective colloid and aggregation of the metal colloid, and, moreover, washing the catalyst during development is often difficult in the process. In addition, during electroless plating, plating is deposited on the unintended part. Furthermore, because of the use of a water-soluble resist and a metal stabilizer, there is a problem of retention of pattern shapes, such as spreading of patterns and thickening of lines. This Patent Document merely discusses the transmittance and resistance values of the resultant transparent conductive film and does not mention the details of the line width (shape) of the resultant pattern.

Transparent electrodes for use in liquid crystal display devices and the like require visibility of images. However, when metal wiring is formed by electroless plating, the formed metal coating film has metallic luster, which reflects external light and makes it difficult to produce a display device that has inconspicuous metal wiring and has high and clear image visibility. For those reasons, in the technique of forming transparent electrodes by electroless plating, there is a demand for preventing metallic luster by blackening on the back surface (transparent base material surface) of the formed metal plating coating film.

In view of such problems, the present invention is then aimed to provide a new primer for electroless plating for use in a pretreatment process of electroless plating, which is environmentally friendly, can be treated in fewer process steps, and can facilitate formation of fine-pitch wiring with a width of a few µm by photolithography. Means for Solving the Problem

The inventors of the present invention have conducted elaborate studies in order to achieve the object above and have found that a layer obtained by producing a photosensitive primer including a hyperbranched polymer having an ammonium group at a molecular terminal and metal fine particles in combination with a certain polymerizable compound and a photopolymerization initiator and applying this photosensitive primer on a base material can be patterned by photolithography to yield a patterned primer layer for electroless metal plating, and that the primer layer has excellent platability and serves as a useful layer for improving adhesion between the metal plating film and the plated base material. The inventors also have found that when the patterned primer layer for electroless metal plating is formed on a transparent base material such as glass and a metal plating coating film is formed thereon, the back surface of the plating coating film-formed portion exhibits a black color. The finding has led to completion of the present invention.

More specifically, according to a first aspect, the present invention relates to a photosensitive primer for forming a metal plating film on a base material through an electroless plating process. The primer comprises:
(a) a hyperbranched polymer having an ammonium group at a molecular terminal and a weight-average molecular weight of 1,000 to 5,000,000;
(b) metal fine particles;
(c) a polymerizable compound having three or more (meth)acryloyl groups in a molecule; and
(d) a photopolymerization initiator.

According to a second aspect, the present invention relates to the photosensitive primer according to the first aspect, in which the polymerizable compound (c) is a compound having three or more (meth)acryloyl groups in a molecule and having an oxyalkylene group.

According to a third aspect, the present invention relates to the photosensitive primer according to the first aspect or the second aspect, in which the photosensitive primer further comprises (e) a urethane (meth)acrylate compound having one or two (meth)acryloyl groups in a molecule.

According to a fourth aspect, the present invention relates to the photosensitive primer according to any one of the first aspect to the third aspect, in which the hyperbranched polymer (a) is a hyperbranched polymer of Formula [1]: 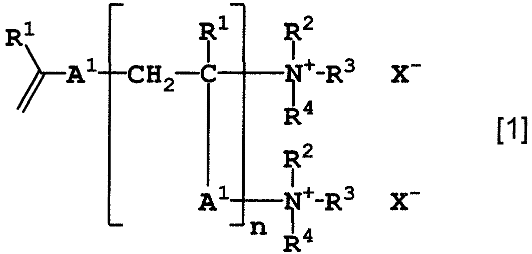 (where R¹ are each independently a hydrogen atom or a methyl group, R² to R⁴ are each independently a hydrogen atom, a linear, branched, or cyclic alkyl group having a carbon atom number of 1 to 20, a C₇₋₂₀ arylalkyl group, or -(CH₂CH₂O)ₙR⁵ (where R⁵ is a hydrogen atom or methyl group, and m is an integer of 2 to 100) (the alkyl group and the arylalkyl group are optionally substituted with an alkoxy group, a hydroxy group, an ammonium group, a carboxy group, or a cyano group), or optionally, two groups of R² to R⁴ together are a linear, branched, or cyclic alkylene group, or R² to R⁴ together with a nitrogen atom to which R² to R⁴ are bonded optionally form a ring, X⁻ is an anion, n is the number of repeating unit structures and an integer of 5 to 100,000, and A¹ is a structure of Formula [2]): 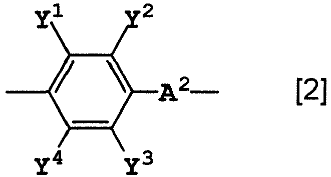 (where A² is a linear, branched, or cyclic alkylene group having a carbon atom number of 1 to 30 optionally containing an ether bond or an ester bond, and Y¹ to Y⁴ are each independently a hydrogen atom, a C₁₋₂₀ alkyl group, a C₁₋₂₀ alkoxy group, a nitro group, a hydroxy group, an amino group, a carboxy group, or a cyano group).

According to a fifth aspect, the present invention relates the photosensitive primer according to the fourth aspect, in which the hyperbranched polymer (a) is a hyperbranched polymer of Formula [3]: 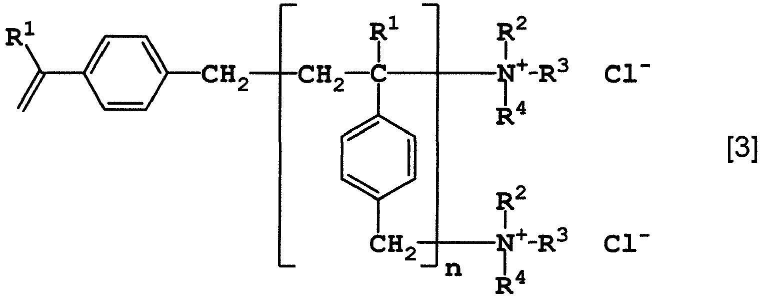 (where R¹ to R⁴ and n have the same meanings as described above).

According to a sixth aspect, the present invention relates to the photosensitive primer according to any one of the first aspect to the fifth aspect, in which the metal fine particles (b) are fine particles of at least one of metal species selected from the group consisting of iron (Fe), cobalt (Co), nickel (Ni), copper (Cu), palladium (Pd), silver (Ag), tin (Sn), platinum (Pt), and gold (Au).

According to a seventh aspect, the present invention relates to the photosensitive primer according to the sixth aspect, in which the metal fine particles (b) are palladium fine particles.

According to an eighth aspect, the present invention relates to the photosensitive primer according to any one of the first aspect to the seventh aspect, in which the metal fine particles (b) are fine particles having an average particle diameter of 1 to 100 nm.

According to a ninth aspect, the present invention relates to the photosensitive primer according to any one of the first aspect to the eighth aspect, in which a pattern is able to be formed by photolithography.

According to a tenth aspect, the present invention relates to a primer layer for electroless plating obtained by forming the photosensitive primer as described in any one of the first aspect to the ninth aspect into a layer and performing photolithography on the layer.

According to an eleventh aspect, the present invention relates to a metal plating film formed on the primer layer for electroless plating as described in the tenth aspect by performing electroless plating on the primer layer.

According to a twelfth aspect, the present invention relates to a metal-coated base material comprising a base material, the primer layer for electroless plating as described in the tenth aspect formed on the base material, and the metal plating film as described in the eleventh aspect formed on the primer layer for electroless plating.

According to a thirteenth aspect, the present invention relates to a method of producing a metal-coated base material, comprising:
step A: applying the photosensitive primer as described in any one of the first aspect to the ninth aspect on a base material to provide a primer layer;
step B: forming a primer layer having a desired pattern by photolithography; and
step C: immersing the base material having the patterned primer layer in an electroless plating bath to form a metal plating film.

### Effects of the Invention

A patterned primer layer for electroless metal plating can be easily formed by applying the photosensitive primer of the present invention on a base material and performing photolithography through a mask.

The photosensitive primer of the present invention can form a primer layer having excellent adhesion to a base material without forming a primer layer, which is conventionally formed on a base material in order to enhance the adhesion to a metal plating film. Furthermore, the photosensitive primer of the present invention can form a plating primer layer patterned on the order of µm and can be suitably used in a variety of wiring techniques.

A metal plating film can be easily formed only by immersing the primer layer for electroless metal plating formed of the photosensitive primer of the present invention in an electroless plating path, and a metal-coated base material including a base material and a primer layer as well as a metal plating film can be easily obtained.

The metal plating film has excellent adhesion to the underlying primer layer.

That is, a metal plating film having excellent adhesion to a base material can be formed by forming a primer layer on a base material using the photosensitive primer of the present invention.

Furthermore, when a metal plating film is formed on the photosensitive primer of the present invention, its back surface exhibits a black color. Therefore, when the metal plating film and the photosensitive primer are formed on a transparent base material such as a glass substrate, a transparent electrode with high image visibility can be expected.

### BRIEF DESCRIPTION OF THE DRAWINGS

[FIG. 1] FIG. 1 shows the ¹H NMR spectrum of a hyperbranched polymer having a chlorine atom at a molecular terminal (HPS-Cl) obtained in Production Example 1.
[FIG. 2] FIG. 2 shows the ¹³C NMR spectrum of a hyperbranched polymer having a dimethyloctylammonium group at a molecular terminal (HPS-N(Me)₂OctCl) produced in Production Example 2.
[FIG. 3] FIG. 3 shows a digital microscopic image of a metal plating film obtained in Example 5.
[FIG. 4] FIG. 4 shows a digital microscopic image of a metal plating film obtained in Example 7.

### MODES FOR CARRYING OUT THE INVENTION

### [Primer]

### <(a) Hyperbranched Polymer>

The hyperbranched polymer (a) for use in the photosensitive primer of the present invention is a polymer having an ammonium group at a molecular terminal and a weight-average molecular weight of 1,000 to 5,000,000. Specific examples thereof include a hyperbranched polymer of Formula [1].

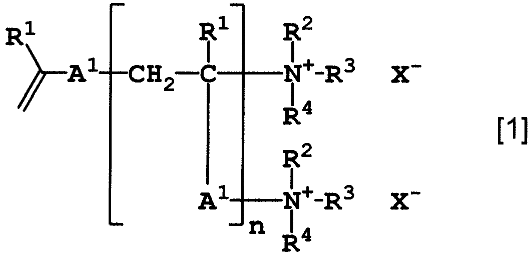

In Formula [1] above, R¹ are each independently a hydrogen atom or a methyl group.

R² to R⁴ are each independently a hydrogen atom, a linear, branched, or cyclic alkyl group having a carbon atom number of 1 to 20, a C₇₋₂₀ arylalkyl group, or -(CH₂CH₂O)ₘR⁵ (where R⁵ is a hydrogen atom or methyl group, and m is any integer of 2 to 100). The alkyl group and the arylalkyl group are optionally substituted with an alkoxy group, a hydroxy group, an ammonium group, a carboxy group, or a cyano group. Alternatively, two groups of R² to R⁴ may together be a linear, branched, or cyclic alkylene group, or R² to R⁴ together with the nitrogen atom to which R² to R⁴ are bonded optionally form a ring.

X⁻ is an anion, and n is the number of repeating unit structures and an integer of 5 to 100,000.

Examples of the linear C₁₋₂₀ alkyl group in R² to R⁴ include methyl group, ethyl group, n-propyl group, n-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, n-nonadecyl group, and n-eicosyl group. A group having eight or more carbon atoms is preferred because the primer with such a group is sparingly soluble in an electroless plating solution and, in particular, n-octyl group is preferred. Examples of the branched alkyl group include isopropyl group, isobutyl group, sec-butyl group, and tert-butyl group. Examples of the cyclic alkyl group include groups having a cyclopentyl ring or cyclohexyl ring structure.

Examples of the C₇₋₂₀ arylalkyl group in R² to R⁴ include benzyl group and phenethyl group.

Examples of the linear alkylene group that two groups of R² to R⁴ together form include methylene group, ethylene group, trimethylene group, tetramethylene group, and hexamethylene group. Examples of the branched alkylene group include methyl ethylene group, butane-1,3-diyl group, and 2-methyl propane-1,3-diyl group. Examples of the cyclic alkylene group include monocyclic, multicyclic, bridged cyclic C₃₋₃₀ alicyclic aliphatic groups. Specific examples thereof include groups having four or more carbon atoms with monocyclic, bicyclic, tricyclic, tetracyclic, or pentacyclic structures. These alkylene groups may contain a nitrogen atom, a sulfur atom, or an oxygen atom in the groups.

The ring that R² to R⁴ together with the nitrogen atom to which R² to R⁴ are bonded form in the structure of Formula [1] may contain a nitrogen atom, a sulfur atom, or an oxygen atom in the ring, and examples thereof include pyridine ring, pyrimidine ring, pyrazine ring, quinoline ring, and bipyridyl ring.

Examples of the combination of R² to R⁴ include [methyl group, methyl group, methyl group], [methyl group, methyl group, ethyl group], [methyl group, methyl group, n-butyl group], [methyl group, methyl group, n-hexyl group], [methyl group, methyl group, n-octyl group], [methyl group, methyl group, n-decyl group], [methyl group, methyl group, n-dodecyl group], [methyl group, methyl group, n-tetradecyl group], [methyl group, methyl group, n-hexadecyl group], [methyl group, methyl group, n-octadecyl group], [ethyl group, ethyl group, ethyl group], [n-butyl group, n-butyl group, n-butyl group], [n-hexyl group, n-hexyl group, n-hexyl group], and [n-octyl group, n-octyl group, n-octyl group]. Among them, the combinations of [methyl group, methyl group, n-octyl group] and [n-octyl group, n-octyl group, n-octyl group] are preferable.

Preferable examples of the anion X⁻ include a halogen atom, PF₆⁻, BF₄⁻, or perfluoroalkane sulfonate.

In Formula [1], A¹ is a structure of Formula [2].

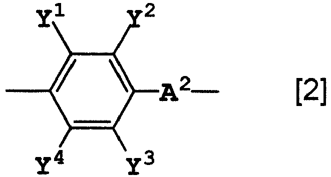

In Formula [2], A² is a linear, branched, or cyclic alkylene group having a carbon atom number of 1 to 30 optionally containing an ether bond or an ester bond.

Y¹ to Y⁴ are each independently a hydrogen atom, a C₁₋₂₀ alkyl group, a C₁₋₂₀ alkoxy group, a nitro group, a hydroxy group, an amino group, a carboxy group, or a cyano group.

Specific examples of the alkylene group of A² include linear alkylene group such as methylene group, ethylene group, trimethylene group, tetramethylene group, and hexamethylene group, and branched alkylene group such as methylethylene group, butane-1,3-diyl group, and 2-methylpropane-1,3-diyl group. Examples of the cyclic alkylene group include monocyclic, multicyclic, and bridged cyclic C₃₋₃₀ alicyclic aliphatic groups. Specific examples thereof include groups having four or more carbon atoms with monocyclic, bicyclic, tricyclic, tetracyclic, and pentacyclic structures. For example, structural examples of the alicyclic moieties (a) to (s) in the alicyclic aliphatic groups are shown below.

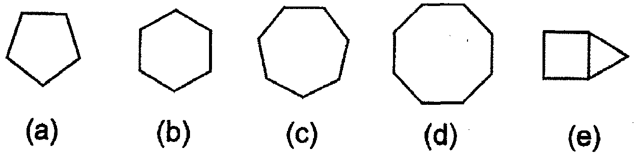

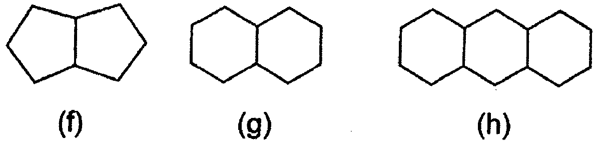

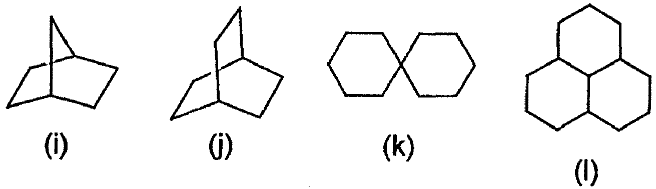

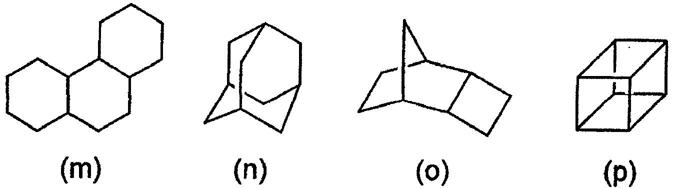

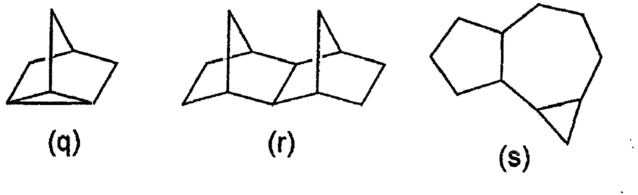

In Formula [2] above, examples of the C₁₋₂₀ alkyl group of Y¹ to Y⁴ include methyl group, ethyl group, isopropyl group, n-pentyl group, and cyclohexyl group. Examples of the C₁₋₂₀ alkoxy group include methoxy group, ethoxy group, isopropoxy group, n-pentyloxy group, and cyclohexyloxy group. Y¹ to Y⁴ are preferably a hydrogen atom or a C₁₋₂₀ alkyl group.

Preferably, examples of the hyperbranched polymer for use in the present invention include a hyperbranched polymer of Formula [3].

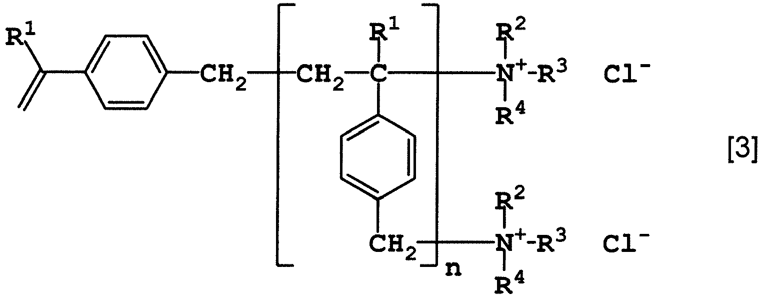

In Formula [3] above, R¹, R², R⁴ and n have the same meanings as described above.

The hyperbranched polymer having an ammonium group at a molecular terminal for use in the present invention can be obtained, for example, by allowing a hyperbranched polymer having a halogen atom at a molecular terminal to react with an amine compound.

A hyperbranched polymer having a halogen atom at a molecular terminal can be produced from a hyperbranched polymer having a dithiocarbamate group at a molecular terminal according to the description of WO2008/029688 Pamphlet. The hyperbranched polymer having a dithiocarbamate group at a molecular terminal is commercially available, and HYPERTECH (registered trademark) HPS-200 manufactured by Nissan Chemical Industries, Ltd. and the like can be suitably used.

Examples of the amine compound that can be used in the reaction include primary amines including: aliphatic amines such as methylamine, ethylamine, n-propylamine, isopropylamine, n-butylamine, isobutylamine, sec-butylamine, tert-butylamine, n-pentylamine, n-hexylamine, n-heptylamine, n-octylamine, n-nonylamine, n-decylamine, n-undecylamine, n-dodecylamine, n-tridecylamine, n-tetradecylamine, n-pentadecylamine, n-hexadecylamine, n-heptadecylamine, n-octadecylamine, n-nonadecylamine, and n-eicosylamine; alicyclic amines such as cyclopentylamine and cyclohexylamine; aralkyl amines such as benzylamine and phenethylamine; and aromatic amines, for example, anilines such as aniline, p-n-butylaniline, p-tert-butylaniline, p-n-octylaniline, p-n-decylaniline, p-n-dodecylaniline, and p-n-tetradecylaniline, naphthylamines such as 1-naphthylamine and 2-naphthylamine, aminoanthracenes such as 1-aminoanthracene and 2-aminoanthracene, aminoanthraquinones such as 1-aminoanthraquinone, aminobiphenyls such as 4-aminobiphenyl and 2-aminobiphenyl, aminofluorenes such as 2-aminofluorene, 1-amino-9-fluorenone, and 4-amino-9-fluorenone, aminoindanes such as 5-aminoindane, aminoisoquinolines such as 5-aminoisoquinoline, and aminophenanthrenes such as 9-aminophenanthrene. Further examples thereof include amine compounds such as N-(tert-butoxycarbonyl)-1,2-ethylenediamine, N-(tert-butoxycarbonyl)-1,3-propylenediamine,
N-(tert-butoxycarbonyl)-1,4-butylenediamine,
N-(tert-butoxycarbonyl)-1,5-pentamethylenediamine,
N-(tert-butoxycarbonyl)-1,6-hexamethylenediamine, N-(2-hydroxyethyl)amine,
N-(3-hydroxypropyl)amine, N-(2-methoxyethyl)amine, and N-(2-ethoxyethyl)amine.

Examples of secondary amines include aliphatic amines such as dimethylamine, diethylamine, di-n-propylamine, diisopropylamine, di-n-butylamine, diisobutylamine, di-sec-butylamine, di-n-pentylamine, ethylmethylamine, methyl-n-propylamine, methyl-n-butylamine, methyl-n-pentylamine, ethylisopropylamine, ethyl-n-butylamine, ethyl-n-pentylamine, methyl-n-octylamine, methyl-n-decylamine, methyl-n-dodecylamine, methyl-n-tetradecylamine, methyl-n-hexadecylamine, methyl-n-octadecylamine, ethylisopropylamine, ethyl-n-octylamine, di-n-hexylamine, di-n-octylamine, di-n-dodecylamine, di-n-hexadecylamine, and di-n-octadecylamine; alicyclic amines such as dicyclohexylamine; aralkyl amines such as dibenzylamine; aromatic amines such as diphenylamine; and nitrogen-containing heterocyclic compounds such as phthalimide, pyrrole, piperidine, piperazine, and imidazole. Further examples thereof include bis(2-hydroxyethyl)amine, bis(3-hydroxypropyl)amine, bis(2-ethoxyethyl)amine, and bis(2-propoxyethyl)amine.

Examples of tertiary amines include aliphatic amines such as trimethylamine, triethylamine, tri-n-propylamine, tri-n-butylamine, tri-n-pentylamine, tri-n-hexylamine, tri-n-octylamine, tri-n-dodecylamine, dimethylethylamine, dimethyl-n-butylamine, dimethyl-n-hexylamine, dimethyl-n-octylamine, dimethyl-n-decylamine, diethyl-n-decylamine, dimethyl-n-dodecylamine, dimethyl-n-tetradecylamine, dimethyl-n-hexadecylamine, dimethyl-n-octadecylamine, and dimethyl-n-eicosylamine; and nitrogen-containing heterocyclic compounds such as pyridine, pyrazine, pyrimidine, quinoline, 1-methylimidazole, 4,4'-bipyridyl, and 4-methyl-4,4'-bipyridyl.

The amine compound can be used in the reaction in 0.1 molar equivalent to 20 molar equivalents, preferably 0.5 molar equivalent to 10 molar equivalents, and more preferably 1 molar equivalent to 5 molar equivalents per mole of halogen atom of the hyperbranched polymer having a halogen atom at a molecular terminal.

The reaction between the hyperbranched polymer having a halogen atom at a molecular terminal and the amine compound can be carried out in water or an organic solvent in the presence or absence of a base. The solvent used is preferably capable of dissolving the hyperbranched polymer having a halogen atom at a molecular terminal and the amine compound. A solvent capable of dissolving the hyperbranched polymer having a halogen atom at a molecular terminal and the amine compound and incapable of dissolving a hyperbranched polymer having an ammonium group at a molecular terminal is more suitable for easy isolation.

Any solvent may be used in the reaction as long as the solvent does not substantially inhibit the progress of the reaction, and examples thereof include water; alcohols such as 2-propanol; organic acids such as acetic acid; aromatic hydrocarbons such as benzene, toluene, xylene, ethylbenzene, and 1,2-dichlorobenzene; ethers such as tetrahydrofuran (THF) and diethyl ether; ketones such as acetone, methyl ethyl ketone (MEK), methyl isobutyl ketone (MIBK), and cyclohexanone; halides such as chloroform, dichloromethane, and 1,2-dichloroethane; aliphatic hydrocarbons such as n-hexane, n-heptane, and cyclohexane; and amides such as N,N-dimethylformamide (DMF), N,N-dimethylacetamide, and N-methyl-2-pyrrolidone (NMP). These solvents may be used singly or in combination of two or more. The amount of the solvent used is 0.2 to 1,000 times, preferably 1 to 500 times, more preferably 5 to 100 times, and most preferably 5 to 50 times the mass of the hyperbranched polymer having a halogen atom at a molecular terminal.

As a suitable base, commonly used are inorganic compounds including alkali metal hydroxides and alkaline-earth metal hydroxides (for example, sodium hydroxide, potassium hydroxide, and calcium hydroxide), alkali metal oxides and alkaline-earth metal oxides (for example, lithium oxide, and calcium oxide), alkali metal hydrides and alkaline-earth metal hydrides (for example, sodium hydride, potassium hydride, and calcium hydride), alkali metal amides (for example, sodium amide), alkali metal carbonates and alkaline-earth metal carbonates (for example, lithium carbonate, sodium carbonate, potassium carbonate, and calcium carbonate), and alkali metal bicarbonates (for example, sodium bicarbonate), and organometallic compounds including alkali metal alkyls, alkyl magnesium halides, alkali metal alkoxides, alkaline-earth metal alkoxides, and dimethoxymagnesium. Potassium carbonate and sodium carbonate are particularly preferable. It is preferable that the base is used in 0.2 molar equivalent to 10 molar equivalents, preferably 0.5 molar equivalent to 10 molar equivalents, and most preferably 1 molar equivalent to 5 molar equivalents per mole of halogen atom of the hyperbranched polymer having a halogen atom at a molecular terminal.

In this reaction, oxygen in the reaction system is preferably sufficiently removed before this reaction is started, and the system may be purged with inert gases such as nitrogen and argon. The reaction condition is appropriately selected from the reaction time of 0.01 hour to 100 hours and the reaction temperature of 0°C to 300°C. Preferably, the reaction time is 0.1 hour to 72 hours, and the reaction temperature is 20°C to 150°C.

When a tertiary amine is used, the hyperbranched polymer of Formula [1] can be obtained whether or not a base is present.

When a primary amine or a secondary amine compound is reacted with a hyperbranched polymer having a halogen atom at a molecular terminal in the absence of a base, a hyperbranched polymer with a terminal ammonium group, in which the corresponding secondary amine terminal group or tertiary amine terminal group of hyperbranched polymer is protonated, can be obtained. Even when a base is used in the reaction, the reactant may be mixed with an aqueous solution of an acid such as hydrogen chloride, hydrogen bromide, and hydrogen iodide in an organic solvent to obtain a hyperbranched polymer with a terminal ammonium group, in which the corresponding secondary amine terminal group or tertiary amine terminal group of the corresponding hyperbranched polymer is protonated.

The weight-average molecular weight Mw of the hyperbranched polymer measured by gel permeation chromatography in terms of polystyrene is 1,000 to 5,000,000, more preferably 2,000 to 200,000, and most preferably 3,000 to 100,000. The degree of distribution Mw (weight-average molecular weight)/Mn (number-average molecular weight) is 1.0 to 7.0, preferably 1.1 to 6.0, and more preferably 1.2 to 5.0.

### <(b) Metal Fine Particles>

The metal fine particles (b) for use in the photosensitive primer of the present invention are not limited, and examples of metal species include iron (Fe), cobalt (Co), nickel (Ni), copper (Cu), palladium (Pd), silver (Ag), tin (Sn), platinum (Pt), and gold (Au), and alloys thereof. These metals may be used singly or in combination of two or more. Among these, preferable metal fine particles include palladium fine particles. Oxides of the metals may also be used as metal fine particles.

The metal fine particles are obtained by reduction of a metal ion, for example, by irradiating an aqueous solution of a metal salt with a high-pressure mercury lamp or adding a compound having a reducing action (reducing agent) to the aqueous solution. For example, a metal ion may be reduced by, for example, adding an aqueous solution of a metal salt to a solution in which the hyperbranched polymer is dissolved and irradiating the resultant mixture with ultraviolet light or adding an aqueous solution of a metal salt and a reducing agent to the hyperbranched polymer solution, to form a complex of the hyperbranched polymer and the metal fine particles, concurrently with the preparation of a primer including the hyperbranched polymer and the metal fine particles.

Examples of the metal salt include chloroauric acid, silver nitrate, copper sulfate, copper nitrate, copper acetate, tin chloride, platinous chloride, chloroplatinic acid, Pt(dba)₂ [dba=dibenzylideneacetone], Pt(cod)₂ [cod=1,5-cyclooctadiene], Pt(CH₃)₂(cod), palladium chloride, palladium acetate (Pd(OC(=O)CH₃)₂), palladium nitrate, Pd₂(dba)₃.CHCl₃, Pd(dba)₂, rhodium chloride, rhodium acetate, ruthenium chloride, ruthenium acetate, Ru(cod)(cot) [cot=cyclooctatriene], iridium chloride, iridium acetate, and Ni(cod)₂.

The reducing agent is not limited, and various reducing agents can be used. A reducing agent is preferably selected depending on, for example, the metal species added in the intended primer. Examples of the reducing agent that can be used include metal borohydrides such as sodium borohydride and potassium borohydride; aluminum hydrides such as lithium aluminum hydride, potassium aluminum hydride, cesium aluminum hydride, beryllium aluminum hydride, magnesium aluminum hydride, and calcium aluminum hydride; hydrazine compounds; citric acid and salts thereof; succinic acid and salts thereof; ascorbic acid and salts thereof; primary or secondary alcohols such as methanol, ethanol, 2-propanol, and polyol; tertiary amines such as trimethylamine, triethylamine, diisopropylethylamine, diethylmethylamine, tetramethylethylenediamine (TMEDA), and ethylenediaminetetraacetic acid (EDTA); hydroxylamines; and phosphines such as tri-n-propylphosphine, tri-n-butylphosphine, tricyclohexylphosphine, tribenzylphosphine, triphenylphosphine, triethoxyphosphine,
1,2-bis(diphenylphosphino)ethane (DPPE), 1,3-bis(diphenylphosphino)propane (DPPP), 1,1'-bis(diphenylphosphino)ferrocene (DPPF), and
2,2'-bis(diphenylphosphino)-1,1'-binaphthyl (BINAP).

The average particle diameter of the metal fine particles is preferably 1 nm to 100 nm. When an average particle diameter of the metal fine particles is 100 nm or smaller, the surface area is less reduced, and a satisfactory catalytic activity is achieved. The average particle diameter is further preferably 75 nm or smaller and particularly preferably 1 nm to 30 nm.

The amount of the hyperbranched polymer (a) in the photosensitive primer of the present invention is preferably 50 parts by mass to 2,000 parts by mass with respect to 100 parts by mass of the metal fine particles (b). With 50 parts by mass or more, the metal fine particles can be sufficiently dispersed. With 2,000 parts by mass or less, any problems in physical properties resulting from the increase in organic contents can be prevented. More preferably, the amount of the hyperbranched polymer is 100 parts by mass to 1,000 parts by mass.

### <(c) Polymerizable Compound Having Three or More (Meth)acryloyl Groups in Molecule>

Preferable examples of the polymerizable compound having three or more (meth)acryloyl groups in a molecule (c) (hereinafter simply referred to as polymerizable compound) for use in the photosensitive primer of the present invention include compounds having three or more (meth)acryloyl groups in a molecule and having an oxyalkylene group.

Preferable examples of the oxyalkylene group include C₂₋₄ oxyalkylene groups, and among those, oxyethylene group [-OCH₂CH₂-] or oxypropylene group [-OCH₂C(CH₃)H-] are preferable. A plurality of oxyalkylene groups may be coupled to form a poly(oxyalkylene)group. In this case, one kind of the oxyalkylene groups may be used singly or two or more kinds may be used in combination. When different kinds of oxyalkylene groups are included, the bonding thereof may be either one of block bonding and random bonding.

As used in the present invention, the meth(acrylate) compound refers to both an acrylate compound and a methacrylate compound. For example, (meth)acrylic acid refers to acrylic acid and methacrylic acid.

Examples of the polymerizable compound include polyfunctional monomers containing three or more (meth)acryloyl groups, such as urethane-acrylic, epoxy acrylic, and various kinds of (meth)acrylate compounds.

Among those polymerizable compounds, compounds having three or more (meth)acryloyl groups and having an oxyalkylene group and polyfunctional urethane (meth)acrylate compounds having three or more (meth)acryloyl groups are preferable.

Although examples of preferable compounds as the polymerizable compound (c) in the present invention will be presented below, the polymerizable compound (c) is not limited to those examples.

### [Compound having three or more (meth)acryloyl groups and having an oxyalkylene structure]

### (1) Trifunctional (having three (meth)acryloyl groups) compound

Examples of a compound having three (meth)acryloyl groups and having an oxyalkylene structure (trifunctional compound) include ethylene oxide-modified 1,1,1-trimethylolethane tri(meth)acrylate [the number of moles of ethylene oxide added: 3 to 30], ethylene oxide-modified trimethylolpropane tri(meth)acrylate [the number of moles of ethylene oxide added: 3 to 30], propylene oxide-modified trimethylolpropane tri(meth)acrylate [the number of moles of propylene oxide added: 3 to 30], ethylene oxide-modified glycerol tri(meth)acrylate [the number of moles of ethylene oxide added: 3 to 30], propylene oxide-modified glycerol tri(meth)acrylate [the number of moles of propylene oxide added: 3 to 30], tris(2-(acryloyloxy)ethyl)isocyanurate, and ε-caprolactone-modified tris(2-(acryloyloxy)ethyl)isocyanurate [the number of moles of ε-caprolactone added: 1 to 30].

As the trifunctional compound, a commercially available product can be suitably used, and examples thereof include Viscoat #360 [manufactured by Osaka Organic Chemical Industry Ltd.]; NK Ester A-GLY-9E, NK Ester A-GLY-20E, NK Ester AT-20E [all of the above are manufactured by Shin-Nakamura Chemical Co., Ltd.]; and TMPEOTA, OTA480, and EBECRYL (registered trademark) 135 [all of the above are manufactured by DAICEL-ALLNEX LTD.].

### (2) Tetrafunctional (having four (meth)acryloyl groups) compound

Examples of a compound having four (meth)acryloyl groups and having an oxyalkylene structure (tetrafunctional compound) include ethylene oxide-modified ditrimethylolpropane tetra(meth)acrylate [the number of moles of ethylene oxide added: 4 to 40] and ethylene oxide-modified pentaerythritol tetra(meth)acrylate [the number of moles of ethylene oxide added: 4 to 40].

As the tetrafunctional compound, a commercially available product can be suitably used, and examples thereof include NK Ester ATM-4E, and NK Ester ATM-35E [all of the above are manufactured by Shin-Nakamura Chemical Co., Ltd.]; and EBECRYL (registered trademark) 40 [manufactured by DAICEL-ALLNEX LTD.].

### (3) Penta- or more functional (having five or more (meth)acryloyl groups) compound

Examples of a compound having five or more (meth)acryloyl groups and having an oxyalkylene structure (penta- or more functional compound) include ethylene oxide-modified dipentaerythritol hexa (meth)acrylate [the number of moles of ethylene oxide added: 6 to 60] and ethylene oxide-modified tripentaerythritol octa (meth)acrylate [the number of moles of ethylene oxide added: 6 to 60].

As the penta- or more functional compound, a commercially available product can be suitably used, and examples thereof include NK Ester A-DPH-12E, NK Ester A-DPH-48E, and NK Ester A-DPH-96E [manufactured by Shin-Nakamura Chemical Co., Ltd.].

[Polyfunctional urethane (meth)acrylate compound having three or more (meth)acryloyl groups]

### (1) Trifunctional (having three (meth)acryloyl groups) urethane (meth)acrylate

Specific examples of commercially available products of a polyfunctional urethane (meth)acrylate compound having three (meth)acryloyl groups include NK Oligo UA-7100 [manufactured by Shin-Nakamura Chemical Co., Ltd.]; EBECRYL (registered trademark) 204, EBECRYL 205, EBECRYL 264, EBECRYL 265, EBECRYL 294/25HD, EBECRYL 1259, EBECRYL 4820, EBECRYL 8311, EBECRYL 8465, EBECRYL 8701, EBECRYL 9260, KRM (registered trademark) 8296, and KRM 8667 [all of the above are manufactured by DAICEL-ALLNEX LTD.]; and SHIKOH (registered trademark) UV-7550B, SHIKOH UV-7000B, SHIKOH UV-7510B, SHIKOH UV-7461TE, and SHIKOH UV-2750B [all of the above are manufactured by The Nippon Synthetic Chemical Industry Co., Ltd.].

### (2) Tetrafunctional (having four (meth)acryloyl groups) urethane (meth)acrylate

Specific examples of commercially available products of a polyfunctional urethane (meth)acrylate compound having four (meth)acryloyl groups include EBECRYL (registered trademark) 8210, EBECRYL 8405, and KRM (registered trademark) 8528 [all of the above are manufactured by DAICEL-ALLNEX LTD.]; and SHIKOH (registered trademark) UV-7650B [manufactured by The Nippon Synthetic Chemical Industry Co., Ltd.].

### (3) Penta- or more functional (having five or more (meth)acryloyl groups) urethane (meth)acrylate

Examples of a polyfunctional urethane (meth)acrylate compound having five or more (meth)acryloyl groups (penta- or more functional urethane (meth)acrylate) include a urethane product of pentaerythritol tri(meth)acrylate and hexamethylene diisocyanate, a urethane product of pentaerythritol tri(meth)acrylate and toluene diisocyanate, a urethane product of pentaerythritol tri(meth)acrylate and isophorone diisocyanate, and a urethane product of dipentaerythritol penta(meth)acrylate and hexamethylene diisocyanate.

As the penta- or more functional urethane (meth)acrylate, a commercially available product can be suitably used. Examples thereof include UA-306H, UA-306T, UA-306I, and UA-510H [all of the above are manufactured by KYOEISHA CHEMICAL Co.,LTD]; NK Oligo U-6LPA, NK Oligo U-10HA, NK Oligo U-10PA, NK Oligo U-1100H, NK Oligo U-15HA, NK Oligo UA-53H, and NK Oligo UA-33H [all of the above are manufactured by Shin-Nakamura Chemical Co., Ltd.]; EBECRYL (registered trademark) 220, EBECRYL 1290, EBECRYL 5129, EBECRYL 8254, EBECRYL 8301R, KRM (registered trademark) 8200, KRM 8200AE, KRM 8904, and KRM 8452 [all of the above are manufactured by DAICEL-ALLNEX LTD.]; and SHIKOH (registered trademark) UV-1700B, SHIKOH UV-6300B, SHIKOH UV-7600B, SHIKOH UV-7605B, SHIKOH UV-7610B, SHIKOH UV-7620EA, SHIKOH UV-7630B, SHIKOH UV-7640B, and SHIKOH UV-7650B [all of the above are manufactured by The Nippon Synthetic Chemical Industry Co., Ltd.].

### [Other compounds having three or more (meth)acryloyl groups]

Examples of compounds preferred as the polymerizable compound (c) of the present invention, other than the compound having three or more (meth)acryloyl groups and having an oxyalkylene structure and the polyfunctional urethane (meth)acrylate compound having three or more (meth)acryloyl groups, are presented below.

### (1) Trifunctional (having three (meth)acryloyl groups) compound

Examples of a compound having three (meth)acryloyl groups include 1,1,1-trimethylolethane tri(meth)acrylate, trimethylolpropane tri(meth)acrylate, ditrimethylolpropane tri(meth)acrylate, pentaerythritol tri(meth)acrylate, and glycerol tri(meth)acrylate.

As the compound having three (meth)acryloyl groups, a commercially available product can be suitably used. Examples thereof include Viscoat #295 and Viscoat #300 [all of the above are manufactured by Osaka Organic Chemical Industry Ltd.]; LIGHT ACRYLATE TMP-A, LIGHT ACRYLATE PE-3A, and LIGHT ESTER TMP [all of the above are manufactured by KYOEISHA CHEMICAL Co.,LTD]; NK Ester A-9300, NK Ester A-9300-1CL, NK Ester A-TMM-3, NK Ester A-TMM-3L, NK Ester A-TMM-3 LM-N, NK Ester A-TMPT, and NK Ester TMPT [all of the above are manufactured by Shin-Nakamura Chemical Co., Ltd.]; and PETIA, PETRA, TMPTA, and EBECRYL (registered trademark) 180 [all of the above are manufactured by DAICEL-ALLNEX LTD.].

### (2) Tetrafunctional (having four (meth)acryloyl groups) compound

Examples of a compound having four (meth)acryloyl groups include ditrimethylolpropane tetra(meth)acrylate and pentaerythritol tetra(meth)acrylate.

As the compound having four (meth)acryloyl groups, a commercially available product can be suitably used. Examples thereof include Viscoat #300 [manufactured by Osaka Organic Chemical Industry Ltd.]; LIGHT ACRYLATE PE-4A [manufactured by KYOEISHA CHEMICAL Co.,LTD]; NK Ester AD-TMP and NK Ester A-TMMT [all of the above are manufactured by Shin-Nakamura Chemical Co., Ltd.]; and EBECRYL (registered trademark) 140, EBECRYL 1142, and EBECRYL 180 [all of the above are manufactured by DAICEL-ALLNEX LTD.].

### (3) Penta- or more functional (having five or more (meth)acryloyl groups) compound

Examples of a compound having five or more (meth)acryloyl groups include dipentaerythritol penta (meth)acrylate, dipentaerythritol hexa (meth)acrylate, and tripentaerythritol octa (meth)acrylate.

As the compound having five or more (meth)acryloyl groups, a commercially available product can be suitably used. Examples thereof include Viscoat #802 [manufactured by Osaka Organic Chemical Industry Ltd.]; LIGHT ACRYLATE DPE-6A [manufactured by KYOEISHA CHEMICAL Co.,LTD]; NK Ester A-9550 and NK Ester A-DPH [all of the above are manufactured by Shin-Nakamura Chemical Co., Ltd.]; and DPHA [manufactured by DAICEL-ALLNEX LTD.].

The amount of the polymerizable compound (c) blended in the photosensitive primer of the present invention is preferably 10 parts by mass to 10,000 parts by mass with respect to 100 parts by mass of a complex formed of the hyperbranched polymer and the metal fine particles described later. More preferably, the amount of the polymerizable compound (c) is 100 parts by mass to 2,000 parts by mass. If the amount of the polymerizable compound (c) blended is less than 10 parts by mass, pattern formation of the plating primer layer by photolithography as described later is difficult. If the polymerizable compound (c) blended exceeds 10,000 parts by mass, a metal plating coating film may have a risk of not being formed on the primer layer formed with the primer.

When the photosensitive primer of the present invention includes a urethane (meth)acrylate compound having one or two (meth)acryloyl groups in a molecule (e) described later, these components (c) and (e) are blended such that the total amount of the polymerizable compound (c) and the urethane (meth)acrylate compound having one or two (meth)acryloyl groups in a molecule (e) is 10 parts by mass to 10,000 parts by mass, more preferably 100 parts by mass to 2,000 parts by mass with respect to 100 parts by mass of the complex formed of the hyperbranched polymer and the metal fine particles as described later.

### <(d) Photopolymerization Initiator>

As the photopolymerization initiator (d) for use in the photosensitive primer of the present invention, a known one may be used. Examples thereof include alkylphenones, benzophenones, acylphosphine oxides, Michler's benzoyl benzoates, oxime esters, tetramethylthiuram monosulfides, and thioxanthones.

In particular, photofragmentation-type photo radical polymerization initiators are preferred. Examples of the photofragmentation-type photo radical polymerization initiator include those described in "The Latest UV Curing Technique" (page 159; Publisher: Kazuhiro Takausu; Publishing company: Technical Information Institute Co. Ltd.; published in 1991).

Examples of the commercially available photo radical polymerization initiator include, but not limited to, IRGACURE (registered trademark) 184, IRGACURE 369, IRGACURE 500, IRGACURE 651, IRGACURE 784, IRGACURE 819, IRGACURE 907, IRGACURE 1000, IRGACURE 1300, IRGACURE 1700, IRGACURE 1800, IRGACURE 1850, IRGACURE 2959, IRGACURE CGI1700, IRGACURE CGI1750, IRGACURE CGI1850, IRGACURE CG24-61, IRGACURE TPO, IRGACURE OXE-01, IRGACURE OXE-02, Darocur (registered trademark) 1116, and Darocur 1173 [all of the above are manufactured by BASF Japan Ltd.], and ESACURE KIP150, ESACURE KIP65LT, ESACURE KIP100F, ESACURE KT37, ESACURE KT55, ESACURE KTO46, and ESACURE KIP75 [all of the above are manufactured by Lamberti S.p.A.]. These polymerization initiators may be used in combination.

The amount of the photopolymerization initiator (d) blended in the photosensitive primer of the present invention is, for example, 0.1 % by mass to 100% by mass, preferably 1% by mass to 50% by mass, more preferably 10% by mass to 30% by mass with respect to the polymerizable compound (c), or with respect to the total mass of the polymerizable compound (c) and the urethane (meth)acrylate compound having one or two (meth)acryloyl groups in a molecule (e) when the urethane (meth)acrylate compound having one or two (meth)acryloyl groups in a molecule (e) described later is included in the photosensitive primer.

### <(e) Urethane (Meth)acrylate Compound Having One or Two (Meth)acryloyl Groups in Molecule>

The photosensitive primer of the present invention may further include a urethane (meth)acrylate compound having one or two (meth)acryloyl groups in a molecule in combination.

In the photosensitive primer of the present invention, it is preferable that a polyfunctional urethane (meth)acrylate compound having three or more (meth)acryloyl groups in a molecule is used in the polymerizable compound (c), or the urethane (meth)acrylate compound having one or two (meth)acryloyl groups in a molecule (e) is used in combination, because if so, blackening of the back surface of the metal plating coating film described later can be achieved after the coating film is formed.

### (1) Monofunctional urethane (meth)acrylate

A monofunctional urethane (meth)acrylate compound is not limited to specific examples. For example, polyisocyanate (isocyanate component) is reacted with monool (active hydrogen component) to obtain an isocyanate terminal prepolymer, which is then reacted with a compound having a (meth)acryloyl group and a group reactive with isocyanate to yield a urethane (meth)acrylate having one (meth)acryloyl group on average per molecule. Polyol may be used instead of monool. In this case, manipulation is necessary such that (meth)acryloyloxy group is not introduced to part of the terminal hydroxy group of the polyol.

### (2) Bifunctional urethane (meth)acrylate

Examples of a bifunctional urethane (meth)acrylate include a urethane product of a (meth)acrylic acid adduct of phenyl glycidyl ether and hexamethylene diisocyanate, and a urethane product of a (meth)acrylic acid adduct of phenyl glycidyl ether and toluene diisocyanate.

As the bifunctional urethane (meth)acrylate, a commercially available product can be suitably used. Examples thereof include AH-600 and AT-600 [all of the above are manufactured by KYOEISHA CHEMICAL Co.,LTD]; NK Oligo U-2PPA, NK Oligo U-200PA, NK Oligo UA-160TM, NK Oligo UA-290TM, NK Oligo UA-4200, NK Oligo UA-4400, NK Oligo UA-122P, and NK Oligo UA-W2A [all of the above are manufactured by Shin-Nakamura Chemical Co., Ltd.]; EBECRYL (registered trademark) 210, EBECRYL 215, EBECRYL 230, EBECRYL 244, EBECRYL 245, EBECRYL 270, EBECRYL 280/15IB, EBECRYL 284, EBECRYL 285, EBECRYL 4858, EBECRYL 8307, EBECRYL 8402, EBECRYL 8411, EBECRYL 8804, EBECRYL 8807, EBECRYL 9227EA, EBECRYL 9270, and KRM (registered trademark) 7735 [all of the above are manufactured by DAICEL-ALLNEX LTD.]; and SHIKOH (registered trademark) UV-6630B, SHIKOH UV-7000B, SHIKOH UV-7461TE, SHIKOH UV-2000B, SHIKOH UV-2750B, SHIKOH UV-3000, SHIKOH UV-3200B, SHIKOH UV-3210EA, SHIKOH UV-3300B, SHIKOH UV-3310B, SHIKOH UV-3500BA, SHIKOH UV-3520TL, SHIKOH UV-3700B, and SHIKOH UV-6640B [all of the above are manufactured by The Nippon Synthetic Chemical Industry Co., Ltd.].

In the photosensitive primer of the present invention, when the urethane (meth)acrylate compound having one or two (meth)acryloyl groups in a molecule (e) is used, the amount blended is 200 parts by mass or less with respect to 100 parts by mass of the polymerizable compound (c), preferably 10 parts by mass to 200 parts by mass, more preferably 20 parts by mass to 100 parts by mass. When the urethane (meth)acrylate compound (e) is blended in an amount less than 10 parts by mass, it is difficult to achieve blackening of the back surface of the metal plating coating film. If the urethane (meth)acrylate compound (e) is blended in an amount exceeding 200 parts by mass, pattern formation of the plating primer layer by photolithography may be difficult.

### <Photosensitive Primer>

The photosensitive primer of the present invention includes the hyperbranched polymer having an ammonium group at a molecular terminal (a), the metal fine particles (b), the polymerizable compound (c), and the photopolymerization initiator (d), optionally the urethane (meth)acrylate compound having one or two (meth)acryloyl groups in a molecule (e), and further includes other components. Here, it is preferable that the hyperbranched polymer and the metal fine particles form a complex.

As used herein, the term complex means a state in which the hyperbranched polymer coexists with the metal fine particles so as to be in contact with or in proximity to the metal fine particles through the action of the ammonium group at the terminal of the hyperbranched polymer to form a particulate form. In other words, the complex has a structure in which the ammonium group of the hyperbranched polymer is attached to or coordinates with the metal fine particles.

Accordingly, the "complex" in the present invention includes a complex in which the metal fine particles and the hyperbranched polymer are bonded to form a complex as well as a complex in which the metal fine particles and the hyperbranched polymer exist independently without forming bonds.

The formation of a complex of the hyperbranched polymer having an ammonium group and the metal fine particles is performed concurrently with the preparation of the primer including the hyperbranched polymer and the metal fine particles. Examples of the method include a method in which metal fine particles stabilized to a certain degree with a lower ammonium ligand are manufactured and the ligand is exchanged with the hyperbranched polymer, and a method in which a metal ion is directly reduced in a solution of the hyperbranched polymer having an ammonium group to form a complex. For example, an aqueous solution of a metal salt is added to a solution in which the hyperbranched polymer is dissolved, and the resultant mixture is irradiated with ultraviolet light. Alternatively, an aqueous solution of a metal salt and a reducing agent are added to the hyperbranched polymer solution to reduce the metal ion to form a complex.

In the ligand exchange method, the raw material that is metal fine particles stabilized to a certain degree with a lower ammonium ligand can be manufactured, for example, by the method described in Jounal of Organometallic Chemistry 1996, 520, 143 to 162. A hyperbranched polymer having an ammonium group is dissolved in the resultant reaction mixed solution of the metal fine particles, and the mixture is stirred at room temperature (approximately 25°C) or stirred with heating to obtain the intended metal fine particle complex.

Any solvent may be used as long as the solvent is capable of dissolving the metal fine particles and the hyperbranched polymer having an ammonium group at the necessary concentrations or higher. Specific examples thereof include alcohols such as ethanol, n-propanol, and 2-propanol; halogenated hydrocarbons such as methylene chloride and chloroform; cyclic ethers such as tetrahydrofuran (THF), 2-methyltetrahydrofuran, and tetrahydropyran; nitriles such as acetonitrile and butyronitrile, and a mixture of these solvents. Preferably, tetrahydrofuran is used.

The temperature at which the reaction mixture of the metal fine particles and the hyperbranched polymer having an ammonium group are mixed may be generally from 0°C to the boiling point of the solvent, and preferably in a range of room temperature (approximately 25°C) to 60°C

In the ligand exchange method, a phosphine dispersant (phosphine ligand) may be used instead of the amine dispersant (lower ammonium ligand) to stabilize metal fine particles to a certain degree beforehand.

In the direct reduction method, a metal ion and a hyperbranched polymer having an ammonium group are dissolved in a solvent, and reduction is performed with a primary or secondary alcohol such as methanol, ethanol, 2-propanol, and polyols to obtain the intended metal fine particle complex.

The source of the metal ion used includes the above-noted metal salts.

Any solvent may be used as long as the solvent is capable of dissolving the metal ion and the hyperbranched polymer having an ammonium group to the necessary concentrations or higher. Specific examples thereof include alcohols such as methanol, ethanol, propanol, and 2-propanol; halogenated hydrocarbons such as methylene chloride and chloroform; cyclic ethers such as tetrahydrofuran (THF), 2-methyltetrahydrofuran, and tetrahydropyran; nitriles such as acetonitrile and butyronitrile; amides such as N,N-dimethylformamide (DMF) and N-methyl-2-pyrrolidone (NMP); sulfoxides such as dimethylsulfoxide, and a mixture of these solvents. Preferably, alcohols, halogenated hydrocarbons, and cyclic ethers are used. More preferably, ethanol, 2-propanol, chloroform, tetrahydrofuran, and the like are used.

The temperature for the reduction reaction can be generally from 0°C to the boiling point of the solvent, preferably in a range of room temperature (approximately 25°C) to 60°C.

As another direct reduction method, a metal ion and a hyperbranched polymer having an ammonium group are dissolved in a solvent and allowed to react in a hydrogen atmosphere to obtain the intended metal fine particle complex.

The source of the metal ion used includes the above-noted metal salts and metal carbonyl complexes such as hexacarbonylchromium [Cr(CO)₆], pentacarbonyliron [Fe(CO)₅], octacarbonyldicobalt [Co₂(CO)₈], and tetracarbonylnickel [Ni(CO)₄]. Zero-valent metal complexes such as metal olefin complexes, metal phosphine complexes, and metal nitrogen complexes may also be used.

Any solvent may be used as long as the solvent is capable of dissolving the metal ion and the hyperbranched polymer having an ammonium group to the necessary concentrations or higher. Specific examples thereof include alcohols such as ethanol and propanol; halogenated hydrocarbons such as methylene chloride and chloroform; cyclic ethers such as tetrahydrofuran, 2-methyltetrahydrofuran, and tetrahydropyran; nitriles such as acetonitrile and butyronitrile, and a mixture of these solvents. Preferably, tetrahydrofuran is used.

The temperature at which the metal ion and the hyperbranched polymer having an ammonium group are mixed may be generally from 0°C to the boiling point of the solvent.

As the direct reduction method, a metal ion and a hyperbranched polymer having an ammonium group may be dissolved in a solvent and subjected to thermal decomposition to obtain the intended metal fine particle complex.

The source of the metal ion used includes the above-noted metal salts, metal complexes such as metal carbonyl complexes and other zero-valent metal complexes, and metal oxides such as silver oxide.

Any solvent may be used as long as the solvent is capable of dissolving the metal ion and the hyperbranched polymer having an ammonium group to the necessary concentrations or higher. Specific examples thereof include alcohols such as methanol, ethanol, n-propanol, 2-propanol, and ethylene glycol; halogenated hydrocarbons such as methylene chloride and chloroform; cyclic ethers such as tetrahydrofuran (THF), 2-methyltetrahydrofuran, and tetrahydropyran; nitriles such as acetonitrile and butyronitrile; aromatic hydrocarbons such as benzene and toluene, and a mixture of these solvents. Preferably, toluene is used.

The temperature at which the metal ion and the hyperbranched polymer having an ammonium group are mixed may be generally from 0°C to the boiling point of the solvent. The temperature is preferably close to the boiling point of the solvent, for example, 110°C (heating at reflux) in the case of toluene.

The complex of the hyperbranched polymer having an ammonium group and the metal fine particles thus obtained can be formed as a solid such as powder after purification such as reprecipitation.

The photosensitive primer of the present invention includes the hyperbranched polymer having an ammonium group (a) and the metal fine particles (b) (preferably, a complex formed thereof), the polymerizable compound (c) and the photopolymerization initiator (d), optionally the urethane (meth)acrylate compound having one or two (meth)acryloyl groups in a molecule (e), and other components, and may be in the form of varnish that is used for forming the [primer layer for electroless plating] as described later.

### <Other Additives>

The photosensitive primer of the present invention may further appropriately contain additives such as a surfactant and various kinds of surface conditioners and additives such as a sensitizer, a polymerization inhibitor, and a polymerization initiator as long as the effect of the present invention is not impaired.

Examples of the surfactant include polyoxyethylene alkyl ethers such as polyoxyethylene lauryl ether, polyoxyethylene stearyl ether, polyoxyethylene cetyl ether, and polyoxyethylene oleyl ether; polyoxyethylene alkylaryl ethers such as polyoxyethylene octylphenyl ether and polyoxyethylene nonylphenyl ether; polyoxyethylene-polyoxypropylene block copolymers; sorbitan fatty acid esters such as sorbitan monolaurate, sorbitan monopalmitate, sorbitan monostearate, sorbitan monooleate, sorbitan tristearate, and sorbitan trioleate; polyoxyethylene nonionic surfactants such as polyoxyethylene sorbitan monolaurate, polyoxyethylene sorbitan monopalmitate, polyoxyethylene sorbitan monostearate, and polyoxyethylene sorbitan trioleate; and fluorine-based surfactants such as EFTOP (registered trademark) EF-301, EFTOP EF-303, and EFTOP EF-352 [manufactured by Mitsubishi Materials Electronic Chemicals Co., Ltd.], MEGAFAC (registered trademark) F-171, MEGAFAC F-173, MEGAFAC R-08, and MEGAFAC R-30 [manufactured by DIC Corporation], Novec (registered trademark) FC-430 and Novec FC-431 [manufactured by Sumitomo 3M Ltd.], ASAHI GUARD (registered trademark) AG-710 [manufactured by Asahi Glass Co., Ltd.], and SURFLON (registered trademark) S-382 [manufactured by AGC Seimi Chemical Co., Ltd.].

Examples of the surface conditioner include silicone-based leveling agents such as Shin-Etsu Silicone (registered trademark) KP-341 [manufacture by Shin-Etsu Chemical Co., Ltd.]; and silicone-based surface conditioners such as BYK (registered trademark)-302, BYK-307, BYK-322, BYK-323, BYK-330, BYK-333, BYK-370, BYK-375, and BYK-378 [manufactured by BYK Japan KK].

These additives may be used singly or may be used in combination of two or more. The additives are used in an amount of preferably 0.001 part by mass to 50 parts by mass, more preferably 0.005 part by mass to 10 parts by mass, and even more preferably 0.01 part by mass to 5 parts by mass with respect to 100 parts by mass of the complex formed of the hyperbranched polymer and the metal fine particles.

### [Primer Layer for Electroless Plating]

The photosensitive primer of the present invention may be applied on a base material to form a thin film, which is then subjected to photolithography to form a patterned primer layer for electroless plating. The present invention is also directed to the primer layer.

The base material is not limited, and a nonconducting base material or a conducting base material may be preferably used.

Examples of the nonconducting base material include glass, ceramics; polyethylene resins, polypropylene resins, vinyl chloride resins, nylons (polyamide resins), polyimide resins, polycarbonate resins, acrylic resins, PEN (polyethylene naphthalate) resins, PET (polyethylene terephthalate) resins, PEEK (polyether ether ketone) resins, ABS (acrylonitrile-butadiene-styrene copolymer) resins, epoxy resins, and polyacetal resins; and paper. The nonconducting base material is suitably used in the form of sheet, film, or the like, and in these cases, the thickness is not limited.

Examples of the conducting base material include metals such as ITO (tin-doped indium oxide), ATO (antimony-doped tin oxide), FTO (fluorine-doped tin oxide), AZO (aluminum-doped zinc oxide), GZO (gallium-doped zinc oxide), various stainless steels, aluminum and aluminum alloys such as duralumin, iron and iron alloys, copper and copper alloys such as brass, phosphor bronze, cupronickel, and beryllium copper, nickel and nickel alloys, and silver and silver alloys such as nickel silver.

Furthermore, a base material in which a thin film of any of these conducting base materials is formed on the nonconducting base material is also usable.

The base material may also be a three-dimensionally formed body.

The specific method to form a primer layer for electroless plating from the photosensitive primer containing the hyperbranched polymer having an ammonium group, the metal fine particles, the polymerizable compound, and the photopolymerization initiator is as follows. First, the hyperbranched polymer having an ammonium group and the metal fine particles (preferably a complex formed thereof), the polymerizable compound, and the photopolymerization initiator are dissolved or dispersed in a suitable solvent to form a varnish. The varnish is applied on a base material on which a metal plating coating film is to be formed, for example, by spin coating; blade coating; dip coating; roll coating; bar coating; die coating; spray coating; ink jet method; pen lithography such as fountain-pen nanolithography (FPN) and dip-pen nanolithography (DPN); relief printing such as letterpress printing, flexography, resin relief printing, contact printing, microcontact printing (µCP), nanoimprinting lithography (NIL), and nanotransfer printing (nTP); intaglio printing such as gravure printing and engraving; planographic printing; stencil printing such as screen printing and mimeograph; or offset printing. The solvent is then evaporated and dried to form a thin layer.

Among these application methods, spin coating, spray coating, ink jet method, pen lithography, contact printing, µCP, NIL, and nTP are preferred. Spin coating has advantages in that a highly volatile solution can be used because the application requires a short time and that a highly uniform coating can be obtained. Spray coating needs only a very small amount of vanish to obtain a highly uniform coating, which is industrially very advantageous. Inkjet method, pen lithography, contact printing, µCP, NIL, and nTP can form (draw), for example, fine patterns such as wiring efficiently, which is industrially very advantageous.

Any solvent can be used as long as the solvent dissolves or disperses the complex, the polymerizable compound, and the photosensitive initiator. Examples thereof include water; aromatic hydrocarbons such as benzene, toluene, xylene, ethylbenzene, chlorobenzene, and dichlorobenzene; alcohols such as methanol, ethanol, n-propanol, 2-propanol, n-butanol, 2-butanol, n-hexanol, n-octanol, 2-octanol, and 2-ethylhexanol; cellosolves such as methyl cellosolve, ethyl cellosolve, butyl cellosolve, and phenyl cellosolve; glycol ethers such as propylene glycol monomethyl ether (PGME), propylene glycol monoethyl ether, propylene glycol monobutyl ether, diethylene glycol monomethyl ether, diethylene glycol monobutyl ether, dipropylene glycol monomethyl ether, triethylene glycol monomethyl ether, tripropylene glycol monomethyl ether, ethylene glycol dimethyl ether, propylene glycol dimethyl ether, diethylene glycol dimethyl ether, diethylene glycol diethyl ether, diethylene glycol dibutyl ether, diethylene glycol ethyl methyl ether, diethylene glycol butyl methyl ether, diethylene glycol isopropyl methyl ether, dipropylene glycol dimethyl ether, triethylene glycol dimethyl ether, and tripropylene glycol dimethyl ether; glycol esters such as ethylene glycol monomethyl ether acetate, and propylene glycol monomethyl ether acetate (PGMEA); ethers such as tetrahydrofuran (THF), methyltetrahydrofuran, 1,4-dioxane, and diethyl ether; esters such as ethyl acetate and butyl acetate; ketones such as acetone, methyl ethyl ketone (MEK), methyl isobutyl ketone (MIBK), cyclopentanone, and cyclohexanone; aliphatic hydrocarbons such as n-heptane, n-hexane, and cyclohexane; halogenated aliphatic hydrocarbons such as 1,2-dichloroethane and chloroform; amides such as N-methyl-2-pyrrolidone (NMP), N,N-dimethylformamide (DMF), and N,N-dimethylacetamide; and dimethyl sulfoxide. These solvents may be used singly, or two or more solvents may be mixed. Glycols such as ethylene glycol, propylene glycol, and butylene glycol may be added to adjust the viscosity of the varnish.

The complex, the polymerizable compound, and the photosensitive initiator are dissolved or dispersed in the solvent at any concentration. The concentration of the non-solvent components in the varnish [the concentration of all components included in the photosensitive primer, excluding the solvent (the hyperbranched polymer and the metal fine particles (preferably a complex thereof), the polymerizable compound, the photopolymerization initiator, optionally the urethane (meth)acrylate compound, and other additives)] is 0.05% by mass to 90% by mass, preferably 0.1 % by mass to 80% by mass.

The method for drying the solvent is not limited. For example, a hotplate or an oven can be used to evaporate the solvent in an appropriate atmosphere, that is, air, inert gas such as nitrogen, or in vacuum. This can provide a primer layer having a uniformly formed film surface. The baking temperature is not limited as long as the solvent can be evaporated, and a temperature of 40°C to 250°C is preferably used.

The thus obtained thin film is subsequently exposed through a mask having a predetermined pattern with exposure energy of approximately 10 mJ/cm² to 3,000 mJ/cm² and then developed using a developer to wash out the exposed portion. The patterned primer layer for electroless plating is thus obtained.

In the exposure, ultraviolet radiation of mercury lamps or the like, far-ultraviolet radiation, electron beams, X-rays, or the like is used. Examples of the light source for ultraviolet radiation include sunlight, chemical lamps, low-pressure mercury lamps, high-pressure mercury lamps, metal halide lamps, xenon lamps, and UV-LEDs.

The development method is not limited to any particular method. Known methods such as a liquid filling method, a puddle method, a dipping method, a spraying method, and a vibration dipping method can be used. The development temperature is preferably from 20°C to 50°C, and the development time is for example, 10 seconds to 10 minutes.

As the developer, an organic solvent, an alkaline aqueous solution, or the like may be used. Examples of the organic solvent include alcohols such as methanol, ethanol, n-propanol, and 2-propanol; glycol ethers such as methyl cellosolve, ethyl cellosolve, butyl cellosolve, propylene glycol monomethyl ether (PGME), and 3-methoxy-3-methyl-1-butanol; ethers such as diethyl ether, diisopropyl ether, dibutyl ether, tetrahydrofuran (THF), and 1,4-dioxane; ether esters such as propylene glycol monomethyl ether acetate (PGMEA); esters such as ethyl acetate and butyl acetate; ketones such as acetone and cyclohexanone; amides such as N-methyl-2-pyrrolidone (NMP) and N,N-dimethylacetamide (DMAc); and sulfoxides such as dimethyl sulfoxide.

Examples of the alkaline aqueous solution include an aqueous solution of an alkali metal hydroxide such as potassium hydroxide and sodium hydroxide; an aqueous solution of a quaternary ammonium hydroxide such as tetramethylammonium hydroxide, tetraethylammonium hydroxide, and choline; and an aqueous solution of an amine such as ethanolamine, propylamine, ethylenediamine, and morpholine.

These developers may be used singly or two or more kinds may be mixed. Preferable examples of the mixed solution include a PGME/PGMEA mixed solution (mass ratio of 7:3).

Water; and glycols such as ethylene glycol, propylene glycol, and polyethylene glycol may be added to these developers to control the development characteristic. In order to enhance the removability of the unexposed portion, a surfactant and the like may be added.

As the developer, a commercially available product can be suitably used. Examples thereof include OK73 Thinner [TOKYO OHKA KOGYO CO., LTD.].

After development, washing with water or a common organic solvent is preferably performed for, for example, about 20 seconds to 90 seconds. The moisture on the base material is thereafter removed by using compressed air or compressed nitrogen or by air drying by spinning. If necessary, drying with heating is performed using a hot plate or an oven to obtain a patterned primer layer for electroless plating.

[Electroless Plating Process, Metal Plating Film, Metal-Coated Base Material]

The primer layer for electroless plating formed on the base material thus obtained is subjected to electroless plating to form a metal plating film on the primer layer for electroless plating. The present invention is also directed to the metal plating film thus obtained as well as the metal-coated base material having a primer layer for electroless plating and a metal plating film in this order on a base material.

The electroless plating process (step) is not limited, and any commonly known electroless plating process may be used. For example, the common method involves using a conventionally known electroless plating solution and immersing a primer layer for electroless plating formed on the base material in the plating solution (bath).

The electroless plating solution mainly contains a metal ion (a metal salt), a complexing agent, and a reducing agent. Depending on the application, a pH adjusting agent, a pH buffering agent, a reaction accelerator (a second complexing agent), a stabilizer, a surfactant (used for, for example, giving a luster to the plating film and improving wettability of the surface to be treated), and other agents are contained as appropriate.

Examples of the metal for use for the metal plating film formed by electroless plating include iron, cobalt, nickel, copper, palladium, silver, tin, platinum, gold, and alloys thereof. The metal is appropriately selected depending on the purpose.

The complexing agent and the reducing agent may be appropriately selected depending on the metal ion.

The electroless plating solution may be a commercially available plating solution. Preferable examples thereof include electroless nickel plating agents (Melplate (registered trademark) NI series) and electroless copper plating agents (Melplate (registered trademark) CU series) manufactured by Meltex Inc.; electroless nickel plating solutions (ICP Nicoron (registered trademark) series, Top Piena 650), electroless copper plating solutions (OPC-700 electroless copper M-K, ATS Addcopper IW, ATS Addcopper CT, OPC Copper (registered trademark) AF series, OPC Copper HFS, and OPC Copper NCA), an electroless tin plating solution (Substar SN-5), and electroless gold plating solutions (Flash Gold 330, and Self Gold OTK-IT), an electroless silver plating solution (MUDEN SILVER) manufactured by Okuno Chemical Industries Co., Ltd.; an electroless palladium plating solution (Pallet II) and electroless gold plating solutions (Dip G series, NC Gold series) manufactured by Kojima Chemicals Co., Ltd.; an electroless silver plating solution (S-DIA AG-40) manufactured by SASAKI CHEMICAL CO., LTD.; electroless nickel plating solutions (Kanigen (registered trademark) series, SUMER (registered trademark) series, and SUMER (registered trademark) KANIBLACK (registered trademark) series), and an electroless palladium plating solution (S-KPD) manufactured by JAPAN KANIGEN CO., LTD.; electroless copper plating solutions (CUPOSIT (registered trademark) COPPER MIX series, and CIRCUPOSIT (registered trademark) series), electroless palladium plating solutions (PALLAMERSE (registered trademark) series), electroless nickel plating solutions (DURAPOSIT (registered trademark) series), electroless gold plating solutions (AUROLECTROLESS (registered trademark) series), and electroless tin plating solutions (TINPOSIT (registered trademark) series) manufactured by The Dow Chemical Company; electroless copper plating solutions (THRU-CUP (registered trademark) ELC-SP, THRU-CUP PSY, THRU-CUP PCY, THRU-CUP PGT, THRU-CUP PSR, THRU-CUP PEA, and THRU-CUP PMK) manufactured by C. Uyemura & Co., Ltd., and electroless copper plating solutions (Printganth (registered trademark) PV, and Printganth PVE) manufactured by Atotech Japan K.K.

In the electroless plating process, plating bath temperature, pH, immersion time, concentration of metal ion, presence or absence of stirring and stirring speed, presence or absence of feeding of air or oxygen and feeding speed, and other conditions may be adjusted to control the forming speed of a metal coating film and the thickness of the film.

In the metal-coated base material of the present invention in which a metal plating film is formed on the primer layer thus obtained using the photosensitive primer of the present invention, when a transparent base material is used as the base material, the surface seen when the transparent base material is observed from the surface opposite to the metal coating film-formed side can exhibit a black color.

Therefore, since a metal plating film is applied on the primer layer patterned by photolithography to obtain a metal-coated base material in which the back surface of the patterned plating coating film-formed portion is black, the base material can be used as a transparent electrode with high image visibility.

### Examples

The present invention will be described more specifically with reference to Examples, which are not intended to limit the present invention. In Examples, physical properties of the samples were measured by using the following apparatuses under the following conditions.

(1) GPC (Gel Permeation Chromatography)
   Apparatus: HLC-8220GPC manufactured by Tosoh Corporation
   Column: Shodex (registered trademark) GPC KF-804L + KF-803L manufactured by Showa Denko K.K.
   Column temperature: 40°C
   Solvent: tetrahydrofuran
   Detector: UV (254 nm), RI
(2) ¹H NMR Spectrum
   Apparatus: JNM-L400 manufactured by JEOL Ltd.
   Solvent: CDCl₃
   Reference peak: tetramethylsilane (0.00 ppm)
(3) ¹³CNMR Spectrum
   Apparatus: JNM-ECA700 manufactured by JEOL Ltd.
   Solvent: CDCl₃
   Relaxation reagent: chromium trisacetylacetonate (Cr(acac)₃)
   Reference peak: CDCl₃ (77.0 ppm)
(4) ICP Atomic Emission Spectroscopy (inductively coupled plasma atomic emission spectroscopy)
   Apparatus: ICPM-8500 manufactured by Shimadzu Corporation
(5) TEM (transmission electron microscope) Image
   Apparatus: H-8000 manufactured by Hitachi High-Technologies Corporation
(6) Pattern Exposure (mask aligner)
   Apparatus: MA6 manufactured by SUSS MICROTEC AG.
(7) Development
   Apparatus: Compact development apparatus ADE-3000S manufactured by Actes Kyosan inc.
(8) Digital Microscopic Image
   Apparatus: VHX-2000 manufactured by Keyence Corporation

### Abbreviations used are as follows.

HPS: hyperbranched polystyrene [HYPERTECH (registered trademark) HPS-200 manufactured by Nissan Chemical Industries, Ltd.]
BA: butyl acrylate [manufactured by Tokyo Chemical Industry Co., Ltd.]
BP2A-4E: ethylene oxide-modified bisphenol A diacrylate (the number of moles of ethylene oxide added: 4) [NK Ester A-BPE-4 manufactured by Shin-Nakamura Chemical Co., Ltd.]
DD2A: 1,10-decanediol diacrylate [NK Ester A-DOD-N manufactured by Shin-Nakamura Chemical Co., Ltd.]
DP6A-12E: ethylene oxide-modified dipentaerythritol hexaacrylate (the number of moles of ethylene oxide added: 12) [NK Ester A-DPH-12E manufactured by Shin-Nakamura Chemical Co., Ltd.]
G3A-20E: ethylene oxide-modified glycerol triacrylate (the number of moles of ethylene oxide added: 20) [NK Ester A-GLY-20E manufactured by Shin-Nakamura Chemical Co., Ltd.]
P4A-35E: ethylene oxide-modified pentaerythritol tetraacrylate (the number of moles of ethylene oxide added: 35) [NK Ester ATM-35E manufactured by Shin-Nakamura Chemical Co., Ltd.]
T3A-20E: ethylene oxide-modified trimethylolpropane triacrylate (the number of moles of ethylene oxide added: 20) [NK Ester AT-20E manufactured by Shin-Nakamura Chemical Co., Ltd.]
UA4200: polyether skeleton bifunctional urethane acrylate [NK Oligo UA-4200 manufactured by Shin-Nakamura Chemical Co., Ltd.]
UA7100: polyether skeleton trifunctional urethane acrylate [NK Oligo UA-7100 manufactured by Shin-Nakamura Chemical Co., Ltd.]
TPO: diphenyl(2,4,6-trimethylbenzoyl)phosphine oxide (photopolymerization initiator) [IRGACURE (registered trademark) TPO manufactured by BASF Japan Ltd.]
IPA: 2-propanol
IPE: diisopropyl ether
PGME: propylene glycol monomethyl ether
PGMEA: propylene glycol monomethyl ether acetate
PrOH: n-propanol

### [Production Example 1] Production of HPS-Cl

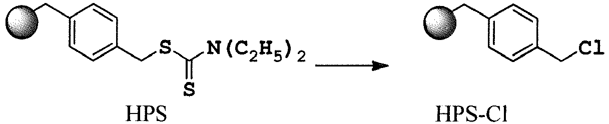

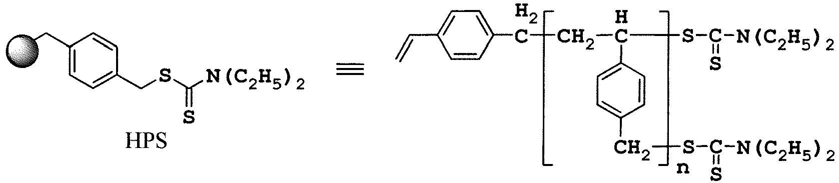

A 500-mL reaction flask was charged with 27 g of sulfuryl chloride [manufactured by KISHIDA CHEMICAL CO., LTD.] and 50 g of chloroform, and the mixture was stirred to be uniformly dissolved. This solution was cooled to 0°C in a nitrogen stream.

Another 300-mL reaction flask was charged with 15 g of a hyperbranched polymer HPS having a dithiocarbamate group at a molecular terminal and 150 g of chloroform, and the mixture was stirred in a nitrogen stream until it became uniform.

The HPS/chloroform solution was added with a feeding pump from the 300-mL reaction flask containing the HPS/chloroform solution to the sulfuryl chloride/chloroform solution cooled to 0°C in a nitrogen stream over 60 minutes so that the temperature of the reaction liquid was from -5°C to 5°C. After the addition was completed, the reaction liquid was stirred for 6 hours while the temperature was kept at -5°C to 5°C.

A solution in which 16 g of cyclohexene [manufactured by Tokyo Chemical Industry Co., Ltd.] was dissolved in 50 g of chloroform was added to this reaction liquid so that the temperature of the reaction liquid became from -5°C to 5°C. After the addition was completed, this reaction liquid was added to 1,200 g of IPA to precipitate the polymer. This precipitate was filtered to obtain a white powder, which was dissolved in 100 g of chloroform. The liquid was added to 500 g of IPA to reprecipitate the polymer. This precipitate was filtered under reduced pressure and vacuum-dried to obtain 8.5 g of a hyperbranched polymer having a chlorine atom at a molecular terminal (HPS-Cl) as a white powder (yield 99%).

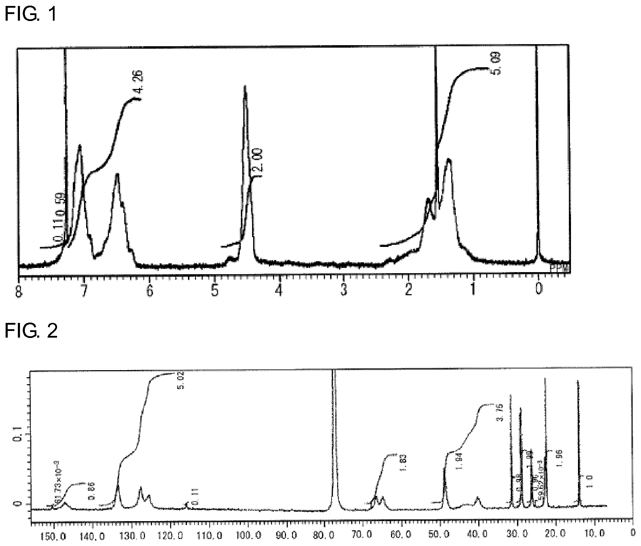

The ¹H NMR spectrum of the obtained HPS-Cl is illustrated in FIG. 1. Since the peaks derived from the dithiocarbamate group (4.0 ppm, 3.7 ppm) disappeared, it was found that almost all the dithiocarbamate groups at the molecular terminals of the HPS were replaced with chlorine atoms in the obtained HPS-Cl. The weight-average molecular weight Mw of the obtained HPS-Cl measured by GPC in terms of polystyrene was 14,000, and the degree of distribution Mw/Mn was 2.9.

### [Production Example 2] Production of HPS-N(Me)₂OctCl

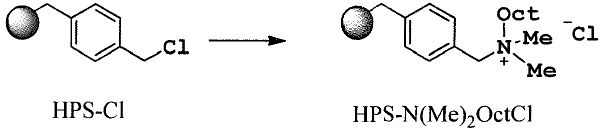

A 100-mL reaction flask equipped with a condenser was charged with 4.6 g (30 mmol) of HPS-Cl produced in Production Example 1 and 15g of chloroform, and the mixture was stirred until it became uniform. To this solution, a solution in which 5.0 g (31.5 mmol) of dimethyloctylamine [FARMIN (registered trademark) DM0898 manufactured by Kao Corporation] was dissolved in 7.5 g of chloroform was added, and 7.5 g of IPA was further added thereto. This mixture was stirred in a nitrogen atmosphere at 65°C for 40 hours.

After the mixture was cooled to a liquid temperature of 30°C, the solvent was distilled off. The resultant residue was dissolved in 60 g of chloroform, and the solution was added to 290 g of IPE for purification by reprecipitation. The precipitated polymer was filtered under reduced pressure and vacuum-dried at 50°C to obtain 9.3 g of a hyperbranched polymer having a dimethyloctylammonium group at a molecular terminal (HPS-N(Me)₂OctCl) as a white powder.

The ¹³C NMR spectrum of the obtained HPS-N(Me)₂OctCl is illustrated in FIG 2. From the peak of the benzene ring and the peak of the methyl group of the octyl group terminal, it was found that, in the obtained HPS-N(Me)₂OctCl the chlorine atoms at the molecular terminals of HPS-Cl were replaced with ammonium groups substantially quantitatively. The weight-average molecular weight (Mw) of HPS-N(Me)₂OctCl calculated from Mw (14,000) of HPS-Cl and the degree of introduction of ammonium group (100%) was 28,000.

### [Production Example 3] Production of HBP-Pd-1

A 100-mL reaction flask equipped with a condenser was charged with 4.2 g of palladium acetate [manufactured by Kawaken Fine Chemicals Co., Ltd.] and 40 g of chloroform, and the mixture was stirred until it became uniform. To this solution, a solution in which 8.0 g of HPS-N(Me)₂OctCl produced in Production Example 2 was dissolved in 100 g of chloroform was added with a dropping funnel. The inside of the dropping funnel was washed with 20 g of chloroform and 40 g of ethanol and the resultant chloroform and ethanol were added to the reaction flask. This mixture was stirred in a nitrogen atmosphere at 60°C for 8 hours.

After the mixture was cooled to a liquid temperature of 30°C, this solution was added to 2,000 g of an IPE/hexane solution (mass ratio: 10:1) for purification by reprecipitation. The precipitated polymer was filtered under reduced pressure and vacuum-dried at 50°C to obtain 8.9 g of a complex of the hyperbranched polymer having an ammonium group at a molecular terminal and Pd particles (Pd[HPS-N(Me)₂OctCl]) as a black powder (HBP-Pd-1).

The result of ICP atomic emission spectroscopy indicated that the Pd content of the resultant Pd[HPS-N(Me)₂OctCl] (HBP-Pd-1) was 20% by mass. The TEM (transmission electron microscope) image indicated that the Pd particles had a particle diameter of approximately 2 nm to 4 nm.

### [Production Example 4] Production of HBP-Pd-2

A 100-mL reaction flask equipped with a condenser was charged with 2.1 g of palladium acetate [manufactured by Kawaken Fine Chemicals Co., Ltd.] and 20 g of chloroform, and the mixture was stirred until it became uniform. To this solution, a solution in which 9.0 g of HPS-N(Me)₂OctCl produced in Production Example 2 was dissolved in 120 g of chloroform was added with a dropping funnel. The inside of the dropping funnel was washed with 20 g of chloroform and 40 g of ethanol and the resultant chloroform and ethanol were added to the reaction flask. This mixture was stirred in a nitrogen atmosphere at 60°C for 8 hours.

After the mixture was cooled to a liquid temperature of 30°C, this solution was added to 2,000 g of an IPE/hexane solution (mass ratio: 10:1) for purification by reprecipitation. The precipitated polymer was filtered under reduced pressure and vacuum-dried at 50°C to obtain 9.3 g of a complex of the hyperbranched polymer having an ammonium group at a molecular terminal and Pd particles (Pd[HPS-N(Me)₂OctCl] as a black powder (HBP-Pd-2).

The result of ICP atomic emission spectroscopy indicated that the Pd content of the resultant Pd[HPS-N(Me)₂OctCl] (HBP-Pd-2) was 10% by mass. The TEM (transmission electron microscope) image indicated that the Pd particles had a particle diameter of approximately 2 nm to 4 nm.

### [Reference Example 1] Preparation of Electroless Nickel Plating Solution

A 2-L beaker was charged with 40 mL of Kanigen (registered trademark) BLUE SUMER [manufactured by Japan Kanigen Co., Ltd.], to which pure water was further added to obtain a total of 200 mL of a solution. This solution was stirred to obtain an electroless nickel plating solution.

### [Example 1]

### [Preparation of Photosensitive Primer]

A photosensitive primer for electroless plating having a concentration of non-solvent components (all components excluding the solvent in the mixture) of 1% by mass was prepared by mixing 8 parts by mass of HBP-Pd-1 produced in Production Example 3 as a Pd catalyst, 80 parts by mass of T3A-20E as a polymerizable compound, 18 parts by mass of TPO as a polymerization initiator, and PrOH as a solvent. The components were dissolved beforehand in part of the amount of PrOH used so that they are easily mixed uniformly.

### [Coating Application]

On a 4-inch wafer-shaped glass substrate, 2.4 mL of the photosensitive primer was spin-coated (200 rpm×5 seconds, followed by 2,000rpm×25 seconds). This base material was dried on a hot plate at 65°C for one minute to obtain a base material having a primer layer on the entire surface of the base material.

### [Patterning (Exposure and Development)]

The resultant primer layer was irradiated with i-ray with a luminance of 9.5 mW/cm² such that exposure energy was 800 mJ/cm² for exposure using a mask aligner equipped with a photomask having a 3 µm-width pattern, in an air atmosphere.

The exposed base material was developed using a development apparatus equipped with a shower nozzle. In the development, while being rotated at 300 rpm, the base material was washed with a PGMEA/PGME solution (mass ratio of 3:7) for 60 seconds, then with 27% by mass PrOH aqueous solution for 60 seconds, and with water for 40 seconds, and thereafter the rotation speed was increased to 2,000 rpm to shake off water.

This base material was dried on a hot plate at 65°C for 30 seconds and then dried on a hot plate at 150°C for 5 minutes to obtain a base material having the patterned primer layer for electroless plating on the base material.

### [Electroless Plating]

The resultant base material was immersed in the electroless nickel plating solution prepared in Reference Example 1 and heated to 80°C, for 3 minutes. Subsequently, the base material was taken out and washed with water, and dried on a hot plate at 100°C for 3 minutes to obtain a plated base material.

For the metal plating film of this plated base material, the plating formation state and the blackening state of the plating coating film-formed portion observed from the back side of the glass substrate were evaluated by visual inspection according to the criteria below. The results are also listed in Table 1.

### <Evaluation Criteria for Plating Formation State >

A: Plating coating film was formed as intended with mask pattern
B: Plating coating film was formed substantially as intended with mask pattern
C: Fail to form patterned plating coating film

### <Evaluation Criteria for Back Surface Blackening>

A: Sufficiently blackened
B: Look brown
C: No effect found

### [Examples 2 to 7]

The manipulation and the evaluation were conducted in the same manner as in Example 1 except that the components of the photosensitive primer were changed as listed in Table 1. The results are also listed in Table 1.

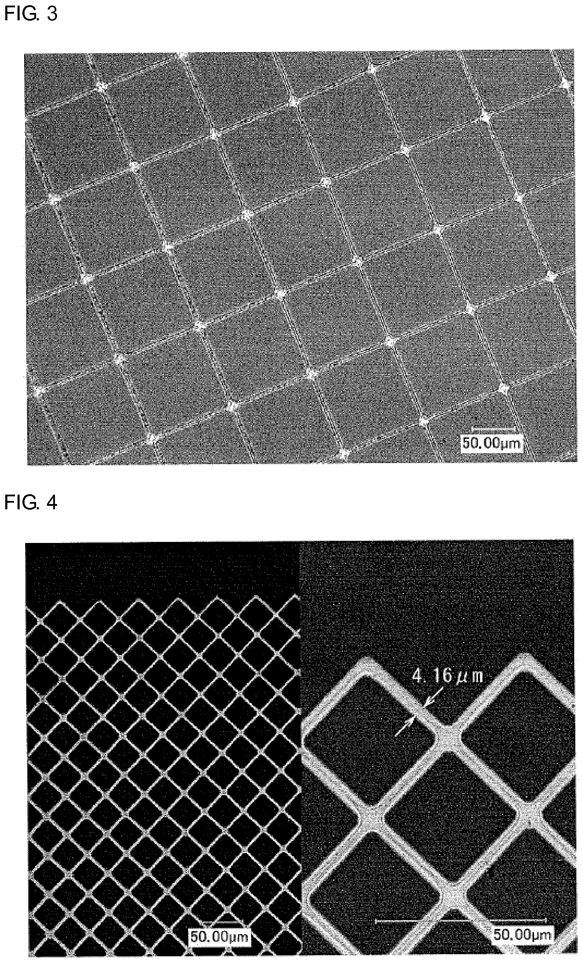

The digital microscopic image of the metal plating film obtained in Example 5 is illustrated in FIG. 3, and the digital microscopic image of the metal plating film obtained in Example 7 is illustrated in FIG. 4.

### [Comparative Examples 1 to 4]

The manipulation and the evaluation were conducted in the same manner as in Example 1 except that the components of the photosensitive primer were changed as listed in Table 1. The results are also listed in Table 1. In any case, a patterned plating coating film was not formed, and the back surface blackening was not evaluated.

[Table 1]

**Table 1**

| | Photosensitive primer | | | | | | | | Plating formation | Back surface blackening |
|---|---|---|---|---|---|---|---|---|---|---|
| | Pd catalyst | | Polymerizable compound | | Mono/bifunctional urethane (meth)acrylate | | TPO [phr] | Solvent | | |
| | Type | [phr] | Type | [phr] | Type | [phr] | | | | |
| Example 1 | **HBP-Pd-1** | **8** | **T3A-20E** | **80** | **none** | **-** | **18** | **PrOH** | **B** | **C** |
| Example 2 | **HBP-Pd-1** | **8** | **G3A-20E** | **80** | **none** | **-** | **18** | **PrOH** | **B** | **C** |
| Example 3 | **HBP-Pd-1** | **8** | **P4A-35E** | **80** | **none** | **-** | **18** | **PGME** | **B** | **C** |
| Example 4 | **HBP-Pd-2** | **8** | **UA7100** | **80** | **none** | **-** | **18** | **PGME** | **B** | **A** |
| Example 5 | **HBP-Pd-2** | **8** | **P4A-35E** | **50** | **none** | **-** | **18** | **PGME** | **A** | **A** |
| | | | **UA7100** | **30** | | | | | | |
| Example 6 | **HBP-Pd-1** | **8.5** | **P4A-35E** | **50** | **UA4200** | **20** | **18.5** | **PrOH** | **A** | **B** |
| Example 7 | **HBP-Pd-1** | **8.5** | **P4A-35E DP6A-12E** | **35 15** | **UA4200** | **25** | **20** | **PrOH** | **A** | **B** |
| Comparative Example 1 | **HBP-Pd-1** | **8** | **BA** | **80** | **none** | **-** | **18** | **PrOH** | **C** | - |
| Comparative Example 2 | **HBP-Pd-1** | **8** | **DD2A** | **80** | **none** | **-** | **18** | **PrOH** | **C** | - |
| Comparative Example 3 | **HBP-Pd-1** | **8** | **BP2A-4E** | **80** | **none** | **-** | **18** | **PrOH** | **C** | - |
| Comparative Example 4 | **HBP-Pd-1** | **8** | **None** | **-** | **UA4200** | **80** | **18** | **PrOH** | **C** | - |

As listed in Table 1, when a plating film was formed on the patterned primer layer for electroless plating obtained by forming a primer layer using the photosensitive primer of the present invention and exposing the primer layer through a mask, followed by development (Example 1 to Example 7), a plating coating film was formed substantially as intended with the mask pattern (see FIG. 3 and FIG. 4). In Example 4 and Example 5 using the polyfunctional urethane (meth)acrylate compound (UA7100) having three or more (meth)acryloyl groups in a molecule as the polymerizable compound (c), and in Example 6 and Example 7 using the urethane (meth)acrylate compound having one or two (meth)acryloyl groups in a molecule (e) (UA4200) in combination, each plating coating film-formed portion observed from the back side of the glass substrate exhibited a black or brown color.

By contrast, in Comparative Example 1 using a compound having one (meth)acryloyl group in a molecule alone as a polymerizable compound, in Comparative Example 2 using a compound having two (meth)acryloyl groups in a molecule alone, and in Comparative Example 4 using a urethane (meth)acrylate compound having two (meth)acryloyl groups in a molecule alone, a patterned plating primer layer was not formed. In Comparative Example 3 using a compound having an oxyalkylene group and having two (meth)acryloyl groups in a molecule alone, a plating primer layer was patterned, but a plating coating film was not formed thereon. In such ways, a patterned plating coating film was not formed in any of Comparative Examples.

Based on the results above, it has been found that the photosensitive primer of the present invention is capable of forming a plating primer layer patterned by photolithography and is advantageous in that a fine-pitch metal plating film with a width of a few µm is obtained.

## Claims

1. A photosensitive primer for forming a metal plating film on a base material through an electroless plating process, the primer comprising:
(a) a hyperbranched polymer having an ammonium group at a molecular terminal and a weight-average molecular weight of 1,000 to 5,000,000;
(b) metal fine particles;
(c) a polymerizable compound having three or more (meth)acryloyl groups in a molecule; and
(d) a photopolymerization initiator.

2. The photosensitive primer according to claim 1, wherein the polymerizable compound (c) is a compound having three or more (meth)acryloyl groups in a molecule and having an oxyalkylene group.

3. The photosensitive primer according to claim 1 or 2, further comprising (e) a urethane (meth)acrylate compound having one or two (meth)acryloyl groups in a molecule.

4. The photosensitive primer according to any one of claims 1 to 3, wherein the hyperbranched polymer (a) is a hyperbranched polymer of Formula [1]: 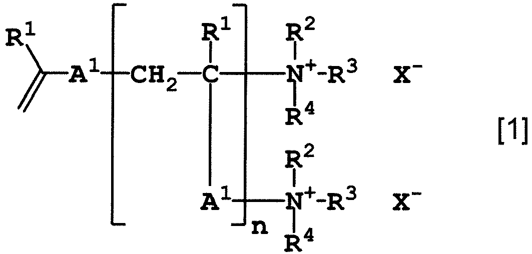 (where R¹ are each independently a hydrogen atom or a methyl group, R² to R⁴ are each independently a hydrogen atom, a linear, branched, or cyclic alkyl group having a carbon atom number of 1 to 20, a C₇₋₂₀ arylalkyl group, or -(CH₂CH₂O)ₘR⁵ (where R⁵ is a hydrogen atom or methyl group, and m is an integer of 2 to 100) (the alkyl group and the arylalkyl group are optionally substituted with an alkoxy group, a hydroxy group, an ammonium group, a carboxy group, or a cyano group), or optionally, two groups of R² to R⁴ together are a linear, branched, or cyclic alkylene group, or R² to R⁴ together with a nitrogen atom to which R² to R⁴ are bonded optionally form a ring, X⁻ is an anion, n is number of repeating unit structures and an integer of 5 to 100,000, and A¹ is a structure of Formula [2]): 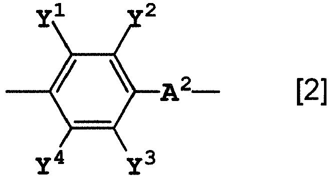 (where A² is a linear, branched, or cyclic alkylene group having a carbon atom number of 1 to 30 optionally containing an ether bond or an ester bond, and Y¹ to Y⁴ are each independently a hydrogen atom, a C₁₋₂₀ alkyl group, a C₁₋₂₀ alkoxy group, a nitro group, a hydroxy group, an amino group, a carboxy group, or a cyano group).

5. The photosensitive primer according to claim 4, wherein the hyperbranched polymer (a) is a hyperbranched polymer of Formula [3]: 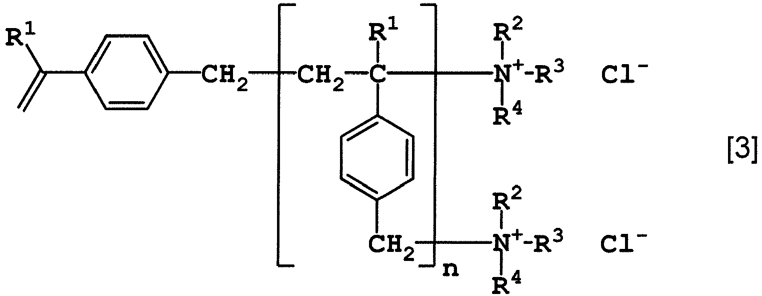 (where R¹ to R⁴ and n have the same meanings as described above).

6. The photosensitive primer according to any one of claims 1 to 5, wherein the metal fine particles (b) are fine particles of at least one of metal species selected from the group consisting of iron (Fe), cobalt (Co), nickel (Ni), copper (Cu), palladium (Pd), silver (Ag), tin (Sn), platinum (Pt), and gold (Au).

7. The photosensitive primer according to claim 6, wherein the metal fine particles (b) are palladium fine particles.

8. The photosensitive primer according to any one of claims 1 to 7, wherein the metal fine particles (b) are fine particles having an average particle diameter of 1 to 100 nm.

9. The photosensitive primer according to any one of claims 1 to 8, wherein a pattern is able to be formed by photolithography.

10. A primer layer for electroless plating obtained by forming the photosensitive primer as claimed in any one of claims 1 to 9 into a layer and performing photolithography on the layer.

11. A metal plating film formed on the primer layer for electroless plating as claimed in claim 10 by performing electroless plating on the primer layer.

12. A metal-coated base material comprising:
a base material;
the primer layer for electroless plating as claimed in claim 10 formed on the base material; and
the metal plating film as claimed in claim 11 formed on the primer layer for electroless plating.

13. A method of producing a metal-coated base material, comprising:
step A: applying the photosensitive primer as claimed in any one of claims 1 to 9 on a base material to provide a primer layer;
step B: forming a primer layer having a desired pattern by photolithography; and
step C: immersing the base material having the patterned primer layer in an electroless plating bath to form a metal plating film.
